# EUROPEAN PATENT APPLICATION

(11) **EP 3 772 792 A1**
(43) Date of publication of application: **10.02.2021**
(21) Application number: 19196934.4
(22) Date of filing: 12.09.2019
(51) Int. Cl.: H02J 3/00, H01H 9/54

(54) **SMART CONTROL SYSTEM**

(30) Priority: 06.08.2019 TW 108127921
(71) Applicant: Climax Technology Co., Ltd., Taipei 114 (TW)
(72) Inventor: WANG, Ku-Fang, 114 Taipei (TW)
(74) Representative: Karakatsanis, Georgios

(57) **Abstract**

A smart control system includes a first unsmart switch disposed in a first electrical outlet box; a second unsmart switch disposed in a second electrical outlet box; and a smart switch electrically connected in series between the first unsmart switch and the second unsmart switch, the smart switch being not disposed in an electrical outlet box.

## Description

### BACKGROUND OF THE INVENTION

### 1. FIELD OF THE INVENTION

The present invention generally relates to a smart control system, and more particularly to a smart control system using a smart switch.

### 2. DESCRIPTION OF RELATED ART

Home intelligent network is capable of controlling home facilities, such as lighting, heating, ventilation, air conditioning appliances, communication systems, entertainment and home security devices, to improve convenience, comfort, energy efficiency and security. Home intelligent network may be used to perform disaster warning and prevention by detecting an event (e.g., smoke or overheat caused by a fire).

In constructing a conventional smart (or intelligent) control system, all conventional switches in a circuit should be removed from electrical outlet (or wall) boxes respectively, followed by installing smart switches in the electrical outlet boxes respectively. A central controller is then used to control the smart switches. The removal and installation commonly take a lot of time and manpower. Moreover, when the central controller fails to work properly, all the smart switches in the circuit would lose ability to switch.

For the foregoing reasons, a need has arisen to propose a novel scheme to improve the smart control system.

### SUMMARY OF THE INVENTION

In view of the foregoing, it is an object of the embodiment of the present invention to provide a smart control system without removing conventional switches from and installing smart switches into electrical outlet boxes as in a conventional smart control system, and being capable of manually performing switching even when a central controller fails to work properly.

According to one embodiment, a smart control system includes a first unsmart switch, a second unsmart switch and a smart switch. The first unsmart switch is disposed in a first electrical outlet box, the second unsmart switch is disposed in a second electrical outlet box, but the smart switch is not disposed in an electrical outlet box. The smart switch is electrically connected in series between the first unsmart switch and the second unsmart switch.

According to another embodiment, a smart control system includes an unsmart switch and a smart switch. The unsmart switch is disposed in an electrical outlet box, but the smart switch is not disposed in an electrical outlet box. The smart switch is electrically connected in series with the unsmart switch.

### BRIEF DESCRIPTION OF THE DRAWINGS

FIG. 1A and FIG. 1B show circuit diagrams illustrating a smart control system according to a first embodiment of the present invention;
FIG. 2 shows a block diagram illustrating the smart switch according to one embodiment of the present invention;
FIG. 3A and FIG. 3B show circuit diagrams illustrating a smart control system according to a second embodiment of the present invention;
FIG. 3C and FIG. 3D show circuit diagrams illustrating a smart control system according to an alternative second embodiment of the present invention;
FIG. 4A and FIG. 4B show circuit diagrams illustrating a smart control system according to a third embodiment of the present invention; and
FIG. 4C and FIG. 4D show circuit diagrams illustrating a smart control system according to an alternative third embodiment of the present invention.

### DETAILED DESCRIPTION OF THE INVENTION

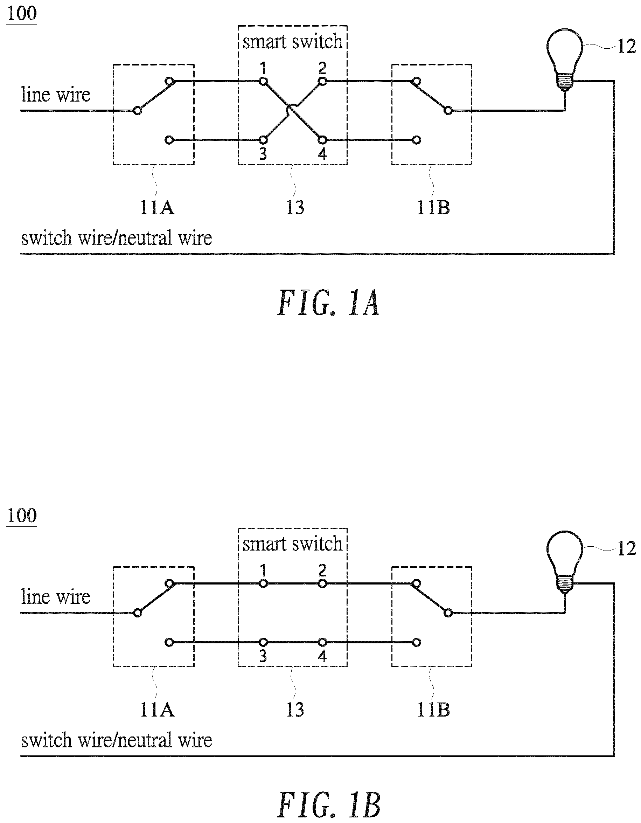

FIG. 1A and FIG. 1B show circuit diagrams illustrating a smart control system 100 according to a first embodiment of the present invention. FIG. 1A/1B exemplifies a two-location switching system, which may be controllably switched on two locations. It is appreciated that the embodiment may be adapted to a multi-location switching system.

In the embodiment, the smart control system 100 may include at least two series-connected switches (e.g., a first switch 11A and a second switch 11B) disposed in electrical outlet boxes (e.g., wall boxes) respectively. It is noted that the first switch 11A and the second switch 11B of the embodiment are conventional mechanical switches, which cannot be controlled via wireless signals and are thus called unsmart switches in this specification. In the embodiment, the first switch 11A may be a single-pole double-throw (SPDT) switch (also called 3-way switch), which may have one input node and two output nodes; the second switch 11B may be a SPDT switch, which may have two input nodes and one output node. The input node of the first switch 11A may be electrically connected to a line (or live) wire of mains power, the output node of the second switch 11B may be electrically connected to a first node of a load 12 (such as a lamp), a second node of which may be electrically connected to a neutral wire of the mains power or connected to a switch wire not from the mains power. In other words, the smart control system 100 of the embodiment needs not to be connected to the neutral wire. The smart control system 100 of the embodiment may be adapted to controlling a variety of lamps such as incandescent lamps, compact fluorescent lamps (CFLs), Tungsten lamps, Halogen lamps or light-emitting diode (LED) lamps. Although a lamp is exemplified in the embodiment, it is appreciated that the embodiment may be adapted to controllably switching other loads such as electric fans or electric curtains.

The smart control system 100 of the embodiment may include a smart switch 13, capable of being controllably switched in a wireless manner, which is electrically connected in series between the first switch 11A and the second switch 11B. In one embodiment, a protocol of a wireless local area network (WLAN), such as Zigbee, Z-Wave or Bluetooth or standards for Sub-1GHz bands or other protocols adaptable to home intelligent network, may be adopted to controllably switch the smart switch 13. According to one aspect of the embodiment, the smart switch 13 is not disposed in an electrical outlet box (e.g., a wall box), while the first switch 11A and the second switch 11B are disposed in electrical outlet boxes respectively.

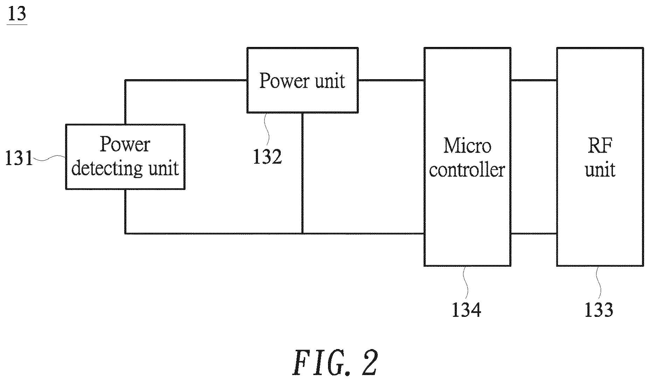

FIG. 2 shows a block diagram illustrating the smart switch 13 according to one embodiment of the present invention. In the embodiment, the smart switch 13 may include a power detecting unit 131 (e.g., a current sensor) configured to detect an input voltage or current. The smart switch 13 may include a power unit 132 (e.g., a charging circuit), which may store power when an input power is detected, and may provide stored power to other circuits of the smart switch 13 when no input power is detected. The smart switch 13 may include a radio frequency (RF) unit 133 configured to receive or generate RF signals. The smart switch 13 may include a micro controller 134 configured to control a switch according to the RF signal received from the RF unit 133 and to generate the RF signal by controlling the RF unit 133 for communicating with a central controller.

In the embodiment, the smart switch 13 may be a 4-way switch, which may have two input nodes as designated as 1 and 3, and may have two output nodes as designated as 2 and 4. When the smart switch 13 is in first state, the input node 1 is connected to the output node 4 and the input node 3 is connected to the output node 2, such that the input nodes pair (1, 3) and the output nodes pair (2, 4) are cross connected as shown in FIG. 1A. When the smart switch 13 is in second state, the input node 1 is connected to the output node 2 and the input node 3 is connected to the output node 4, such that the input nodes pair (1, 3) and the output nodes pair (2, 4) are correspondingly connected as shown in FIG. 1B.

In the embodiment, the two input nodes of the smart switch 13 may be electrically connected to the output nodes of the first switch 11A respectively, and the two output nodes of the smart switch 13 may be electrically connected to the two input nodes of the second switch 11B respectively. As stated above, the smart switch 13 is not disposed in an electrical outlet box, and the first switch 11A and the second switch 11B are disposed in the electrical outlet boxes respectively. To the contrary, all conventional switches in a circuit should be removed from electrical outlet boxes respectively, followed by installing smart switches in the electrical outlet boxes respectively. A central controller is then used to control the smart switches. The embodiment can controllably switch the load 12 by the smart switch 13 without complex and time consuming removal and installation as in the conventional smart control system. Further, when the central controller of the conventional smart control system fails to work properly, all the smart switches in the circuit would lose ability to switch the load 12. On the contrary, the smart control system 100 of the embodiment is capable of controllably switching the load 12 manually through the conventional mechanical first switch 11A and second switch 11B even when the central controller (not shown) fails to work properly.

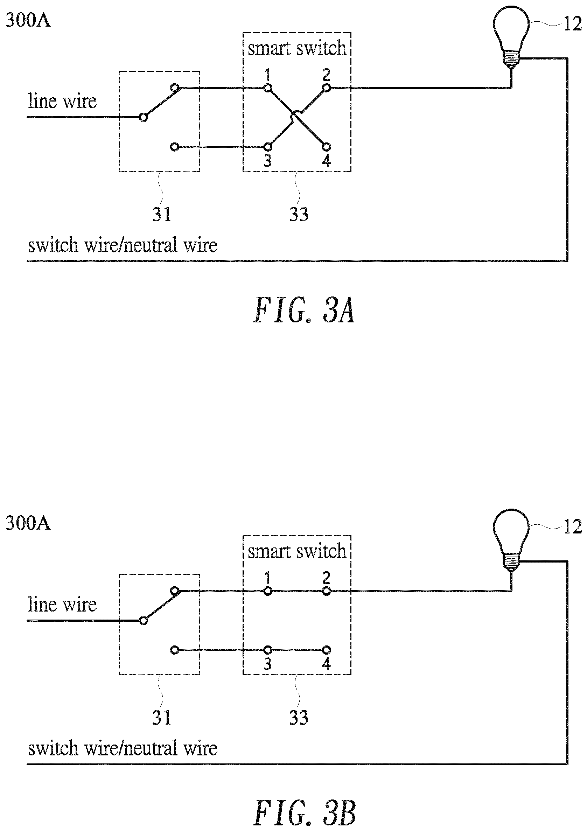

FIG. 3A and FIG. 3B show circuit diagrams illustrating a smart control system 300A according to a second embodiment of the present invention. FIG. 3A/3B exemplifies a one-location switching system, which may be controllably switched on one location.

In the embodiment, the smart control system 300A may include at least one switch (e.g., a switch 31) disposed in an electrical outlet box (e.g., wall box). It is noted that the switch 31 of the embodiment is a conventional mechanical switch, which cannot be controlled via wireless signals and is thus called an unsmart switch in this specification. In the embodiment, the switch 31 may be a single-pole double-throw (SPDT) switch (also called 3-way switch), which may have one input node and two output nodes. The input node of the switch 31 may be electrically connected to a line (or live) wire of mains power, and a second node of a load 12 (such as a lamp) may be electrically connected to a neutral wire of the mains power or connected to a switch wire not from the mains power.

The smart control system 300A of the embodiment may include a smart switch 33, capable of being controllably switched in a wireless manner, which is electrically connected in series with and after the switch 31. According to one aspect of the embodiment, the smart switch 33 is not disposed in an electrical outlet box (e.g., a wall box), while the switch 31 is disposed in an electrical outlet box.

In the embodiment, the smart switch 33 may be a 4-way switch, which may have two input nodes as designated as 1 and 3, and may have two output nodes as designated as 2 and 4. When the smart switch 33 is in first state, the input node 1 is connected to the output node 4 and the input node 3 is connected to the output node 2, such that the input nodes pair (1, 3) and the output nodes pair (2, 4) are cross connected as shown in FIG. 3A. When the smart switch 33 is in second state, the input node 1 is connected to the output node 2 and the input node 3 is connected to the output node 4, such that the input nodes pair (1, 3) and the output nodes pair (2, 4) are correspondingly connected as shown in FIG. 3B.

In the embodiment, the two input nodes of the smart switch 33 may be electrically connected to the output nodes of the switch 31 respectively, and one output node (e.g., output node 2) of the smart switch 33 may be electrically connected to a first node of the load 12.

Similar to the first embodiment, the present embodiment can controllably switch the load 12 by the smart switch 33 without complex and time consuming removal and installation as in the conventional smart control system. Further, the smart control system 300A of the embodiment is capable of controllably switching the load 12 manually through the conventional mechanical switch 31 even when the central controller (not shown) fails to work properly.

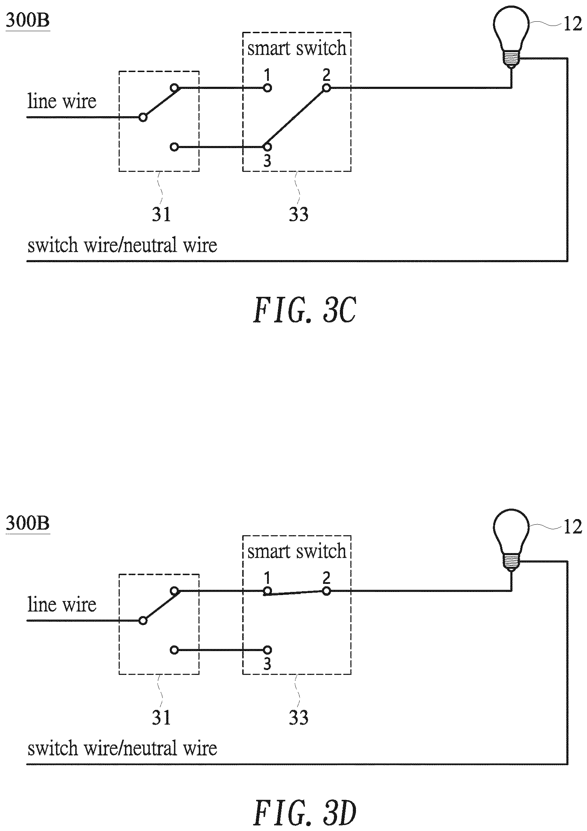

FIG. 3C and FIG. 3D show circuit diagrams illustrating a smart control system 300B according to an alternative second embodiment of the present invention. In the embodiment, the smart switch 33 may be a 3-way switch, which may have two input nodes as designated as 1 and 3, and may have one output node as designated as 2. When the smart switch 33 is in first state, the input node 3 is connected to the output node 2 as shown in FIG. 3C. When the smart switch 33 is in second state, the input node 1 is connected to the output node 2 as shown in FIG. 3D. In the embodiment, the two input nodes of the smart switch 33 may be electrically connected to the output nodes of the switch 31 respectively, and the output node may be electrically connected to a first node of the load 12.

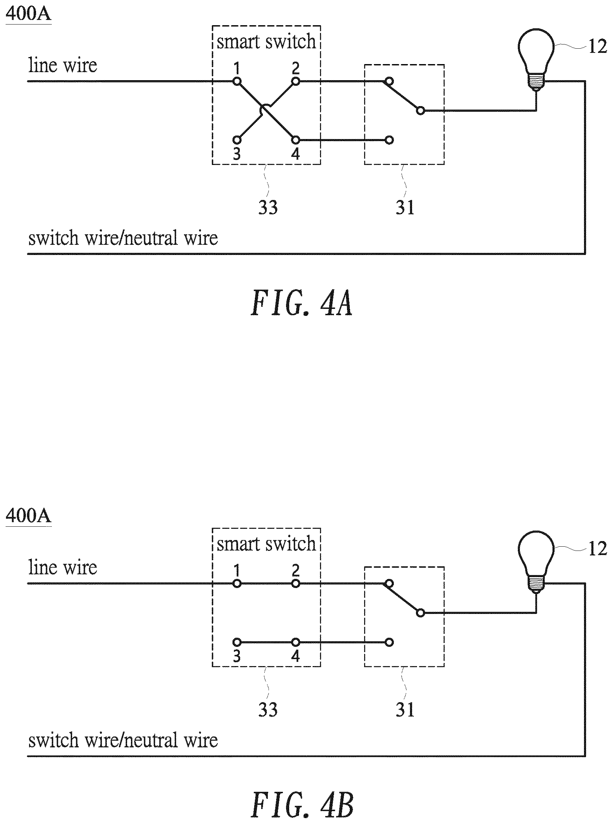

FIG. 4A and FIG. 4B show circuit diagrams illustrating a smart control system 400A according to a third embodiment of the present invention. The present embodiment is similar to the embodiment of FIG. 3A/3B with the exception that the smart switch 33 is electrically connected in series with and before the switch 31. In the embodiment, the switch 31 may be a single-pole double-throw (SPDT) switch (also called 3-way switch), which may have two input nodes and one output node. One input node (e.g., input node 1) may be electrically connected to a line (or live) wire of mains power, and the two output nodes of the smart switch 33 may be electrically connected to the two input nodes of the switch 31 respectively. The output node of the switch 31 may be electrically connected to the first node of the load 12 (such as a lamp), and the second node of the load 12 may be electrically connected to a neutral wire of the mains power or connected to a switch wire not from the mains power.

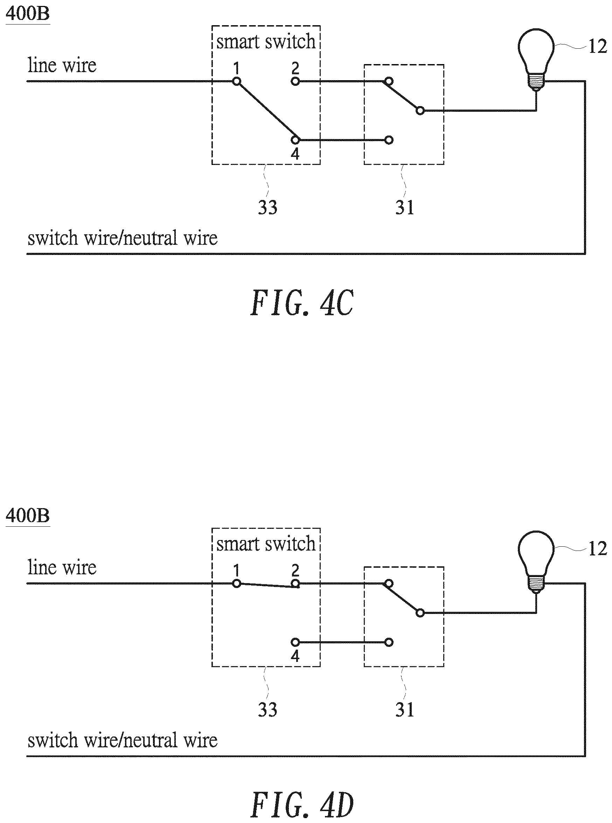

FIG. 4C and FIG. 4D show circuit diagrams illustrating a smart control system 400B according to an alternative third embodiment of the present invention. In the embodiment, the smart switch 33 may be a 3-way switch, which may have one input node as designated as 1, and may have two output nodes as designated as 2 and 4. When the smart switch 33 is in first state, the input node 1 is connected to the output node 4 as shown in FIG. 4C. When the smart switch 33 is in second state, the input node 1 is connected to the output node 2 as shown in FIG. 4D. In the embodiment, the input node may be electrically connected to a line (or live) wire of mains power, and the two output nodes of the smart switch 33 may be electrically connected to the two input nodes of the switch 31 respectively.

## Claims

1. A smart control system, comprising:
a first unsmart switch disposed in a first electrical outlet box;
a second unsmart switch disposed in a second electrical outlet box; and
a smart switch electrically connected in series between the first unsmart switch and the second unsmart switch, the smart switch being not disposed in an electrical outlet box.

2. The system of claim 1, wherein the smart switch comprises a 4-way switch having two input nodes and two output nodes.

3. The system of claim 2, wherein the first unsmart switch comprises a 3-way switch having one input node and two output nodes; and the second unsmart switch comprises a 3-way switch having two input nodes and one output node; wherein the two input nodes of the smart switch are electrically connected to the two output nodes of the first unsmart switch respectively, and the two output nodes of the smart switch are electrically connected to the two input nodes of the second unsmart switch.

4. The system of claim 3, wherein the input node of the first unsmart switch is electrically connected to a line wire, the output node of the second unsmart switch is electrically connected to a first node of a load, and a second node of the load is electrically connected to a neutral wire or a switch wire.

5. The system of claim 1, wherein the smart switch is controllably switched by a wireless local area network.

6. The system of claim 5, wherein the wireless local area network comprises a Zigbee-based, Z-Wave-based or Bluetooth-based protocol, or standards for Sub-1GHz bands.

7. The system of claim 2, wherein input nodes pair and output nodes pair of the smart switch are cross connected when the smart switch is in first state, and the input nodes pair and the output nodes pair of the smart switch are correspondingly connected when the smart switch is in second state.

8. A smart control system, comprising:
an unsmart switch disposed in an electrical outlet box; and
a smart switch electrically connected in series with the unsmart switch, the smart switch being not disposed in an electrical outlet box.

9. The system of claim 8, wherein the smart switch comprises a 4-way switch having two input nodes and two output nodes; or the smart switch comprises a 3-way switch having two input nodes and one output node or having one input node and two output nodes.

10. The system of claim 9, wherein the unsmart switch comprises a 3-way switch having one input node and two output nodes, wherein the two input nodes of the smart switch are electrically connected to the two output nodes of the unsmart switch respectively, and one output node of the smart switch is electrically connected to a first node of a load.

11. The system of claim 10, wherein the input node of the unsmart switch is electrically connected to a line wire, and a second node of the load is electrically connected to a neutral wire or a switch wire.

12. The system of claim 9, wherein the unsmart switch comprises a 3-way switch having two input nodes and one output node, wherein the two output nodes of the smart switch are electrically connected to the two input nodes of the unsmart switch respectively, and the output node of the unsmart switch is electrically connected to a first node of a load.

13. The system of claim 12, wherein one input node of the smart switch is electrically connected to a line wire, and a second node of the load is electrically connected to a neutral wire or a switch wire.

14. The system of claim 8, wherein the smart switch is controllably switched by a wireless local area network.

15. The system of claim 14, wherein the wireless local area network comprises a Zigbee-based, Z-Wave-based or Bluetooth-based protocol, or standards for Sub-1GHz bands.

## Amended claims

### Amended claims in accordance with Rule 137(2) EPC.

1. A smart control system (100/300A/300B/400A/400B), comprising:
a first unsmart switch (11A/31), which cannot be controlled via wireless signals; and
a smart switch (13/33) electrically connected in series with the first unsmart switch, the smart switch being controlled via wireless signals, **characterized in that**
the first unsmart switch is configured to be disposed in a first electrical outlet box, and the smart switch is not configured to be disposed in an electrical outlet box.

2. The smart control system of claim 1, further comprising:
a second unsmart switch (11B) being configured to be disposed in a second electrical outlet box, the second unsmart switch cannot be controlled via wireless signals;
wherein the smart switch (13) is electrically connected in series between the first unsmart switch (11A) and the second unsmart switch.

3. The system of claim 2, wherein the smart switch comprises a 4-way switch having two input nodes and two output nodes.

4. The system of claim 3, wherein the first unsmart switch comprises a 3-way switch having one input node and two output nodes; and the second unsmart switch comprises a 3-way switch having two input nodes and one output node; wherein the two input nodes of the smart switch are electrically connected to the two output nodes of the first unsmart switch respectively, and the two output nodes of the smart switch are electrically connected to the two input nodes of the second unsmart switch.

5. The system of claim 4, wherein the input node of the first unsmart switch is electrically connected to a line wire, the output node of the second unsmart switch is electrically connected to a first node of a load (12), and a second node of the load is electrically connected to a neutral wire or a switch wire.

6. The system of claim 2, wherein the smart switch is controllably switched by a wireless local area network.

7. The system of claim 6, wherein the wireless local area network comprises a Zigbee-based, Z-Wave-based or Bluetooth-based protocol, or standards for Sub-lGHz bands.

8. The system of claim 3, wherein input nodes pair and output nodes pair of the smart switch are cross connected when the smart switch is in first state, and the input nodes pair and the output nodes pair of the smart switch are correspondingly connected when the smart switch is in second state.

9. The system of claim 1, wherein the smart switch (33) comprises a 4-way switch having two input nodes and two output nodes; or the smart switch comprises a 3-way switch having two input nodes and one output node or having one input node and two output nodes.

10. The system of claim 9, wherein the first unsmart switch (31) comprises a 3-way switch having one input node and two output nodes, wherein the two input nodes of the smart switch are electrically connected to the two output nodes of the first unsmart switch respectively, and one output node of the smart switch is electrically connected to a first node of a load (12).

11. The system of claim 10, wherein the input node of the first unsmart switch is electrically connected to a line wire, and a second node of the load is electrically connected to a neutral wire or a switch wire.

12. The system of claim 9, wherein the first unsmart switch comprises a 3-way switch having two input nodes and one output node, wherein the two output nodes of the smart switch are electrically connected to the two input nodes of the first unsmart switch respectively, and the output node of the first unsmart switch is electrically connected to a first node of a load.

13. The system of claim 12, wherein one input node of the smart switch is electrically connected to a line wire, and a second node of the load is electrically connected to a neutral wire or a switch wire.

14. The system of claim 1, wherein the smart switch is controllably switched by a wireless local area network.

15. The system of claim 14, wherein the wireless local area network comprises a Zigbee-based, Z-Wave-based or Bluetooth-based protocol, or standards for Sub-1GHz bands.
